# DEMANDE DE BREVET EUROPEEN

(11) **EP 1 321 965 A1**
(43) Date de publication de la demande: **25.06.2003**
(21) Numéro de dépôt: 01129087.1
(22) Date de dépôt: 07.12.2001
(51) Int. Cl.: H01L 21/00, H05K 13/00, B26D 5/22

(54) **Machine de préformage de transistors**

(71) Demandeur: O.LA.ME.F. di FAUSONE RENZO e C. S.n.c., 14100 Canelli (IT)
(72) Inventeur: D'Andrea, Ivano, 6901 Lugano (CH)
(74) Mandataire: Boggio, Luigi

(57) **Abrégé**

La machine (1) de préformage de transistors comprend au moins des moyens de déplacement (3) pour amener les transistors (T1, T2, T3) dans une position prédéterminée, des moyens de formage (5,6) pour préformer les pattes desdits transistors, des moyens d'évacuation des transistors dont les pattes ont été préformées et des moyens de commande pour coordonner l'action desdits moyens de déplacement, de formage et d'évacuation.

## Description

La présente invention concerne une machine de préformage de pattes de transistors et un procédé de préformage.

Dans la construction de systèmes électroniques, on utilise des circuits imprimés sur lesquels se positionnent un nombre important de composants électroniques. Ce nombre dépend généralement de la complexité des fonctions que le système doit remplir. De plus il existe plusieurs types de composants électroniques, notamment un composant très connu: le transistor.

Dans le cas présent, et à titre d'exemple, nous considérons trois modèles connus sous les codes commerciaux suivants: TO-218, TO-220 et TO-126.

Ces trois modèles sont similaires physiquement, mais ont une dimension différente. Ces composants ont généralement trois pattes de métalliques que l'on nomme. Bien entendu, il existe également des modèle de transistors ayant plus de trois pattes. Ces pattes de contact servent à relier le corps du transistor aux pistes du circuit imprimé sur lequel ils sont montés. Pour faire cette connexion, il y a en général des trous dans le circuit imprimé dans lesquels on introduit les pattes du transistor. Selon la position des trous et celle du transistor, il est nécessaire de procéder à des pliages, que l'on nomme préfaçonnage, ou des coupes des pattes du transistor. Pour effectuer cette opération, on utilise à ce jour des outils manuels (petites presses) avec lesquelles l'opérateur, après avoir positionné manuellement un transistor dans la position correcte, doit appuyer sur un bouton ou une pédale pour activer un système mécanique qui réalise la préforme ou la coupe de la patte de contact.

Le but de l'invention est d'améliorer les systèmes et procédés connus à l'heure actuelle.

Plus particulièrement, la présente invention a pour but de proposer une machine et un procédé permettant un préformage ou une coupe des pattes de contact de manière automatique.

Ce but est atteint par la machine définie dans la revendication indépendante 1 et par le procédé défini dans la revendication indépendante 6.

Des modes d'exécution particuliers de la machine sont définis dans les revendications dépendantes 2 à 5

De même, des étapes particulières du procédé sont définies dans les revendications dépendantes 7 à 9.

L'invention sera mieux comprise par la description d'un mode d'exécution de celle-ci et des figures qui s'y rapportent.

La figure 1 est une première vue en perspective de la machine selon l'invention.

La figure 2 est une deuxième vue en perspective de la machine selon l'invention.

La figure 3 est une vue en coupe verticale de la machine selon l'invention.

La figure 4 montre des exemples de transistors ayant subi un préformage selon l'invention.

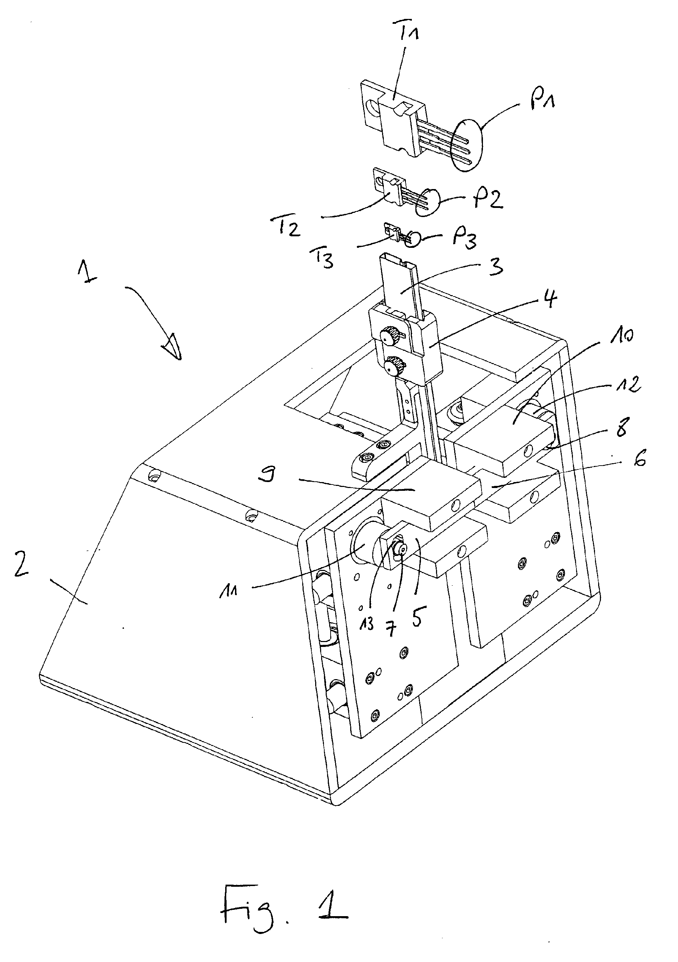

La machine selon l'invention est tout d'abord décrite en référence à la figure 1. Dans cette figure, la machine 1 comprend un boîtier 2 sur lequel est monté une alimentation 3 en transistors T1, T2 ou T3. Ces transistors comprennent des pattes de contact P1, P2 et P3. La taille et la forme de cette alimentation est bien entendu fonction du type de transistor (T1, T2 ou T3) qu'elle contient. L'alimentation fournie contient déjà les transistors (en général 50 pièces). Un système de tenue 4 réglable à molettes permet de maintenir les différentes alimentations qui dépendent du type de transistor pendant le processus de préformage et/ou coupe. Sur la face avant de la machine 1, on trouve deux matrices 5 et 6 qui sont taillées et utilisées pour effectuer le préformage et/ou coupe des pattes de transistor. En effet, elles comportent sur leurs faces qui coopèrent la forme à donner aux pattes du transistor, ou un moyen de coupe pour couper une patte, par exemple pour la raccourcir.

Ces matrices sont adaptées donc à la préforme et/ou coupe à effectuer sur un groupe de transistors, interchangeables et démontables de manière simple, par exemple en enlevant les vis 7 et 8. Ces matrices sont en outre guidées dans les supports 9, 10 qui ont la forme d'un "U". De plus, ces matrices se déplacent latéralement sous l'action de la rotation des arbres, à la manière d'un système à excentrique. En effet, les matrices 5, 6 sont liées aux arbres 11, 12 par un axe 13 dont l'axe longitudinal est excentré par rapport à l'axe longitudinal de l'arbre 11 (ou 12) de sorte qu'une rotation de l'arbre 11 (ou 12) résulte en une translation des matrices 5 et 6. Une translation coordonnée des matrices 5, 6 l'une vers l'autre permet donc de pincer les pattes d'un transistor entre les deux faces de matrices 5, 6 coopérant l'une avec l'autre et par conséquent de préformer, voire de couper, lesdites pattes.

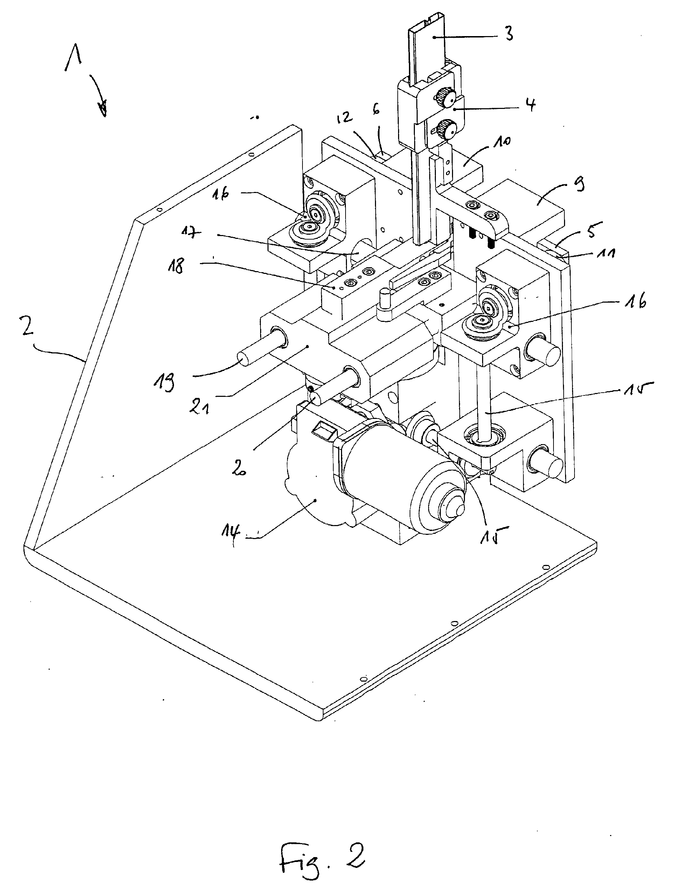

Dans la figure 2, le boîtier 2 de la machine 1 est partiellement ouvert de façon à montrer les éléments composant ladite machine 1. Outre les éléments déjà décrits dont les références numériques sont conservées, on aperçoit sur cette figure un moteur 14 qui commande la majorité des fonctions de la machine au travers d'un système de transmission composé notamment de couples coniques, d'arbres de transmission et d'engrenages coniques 15, 16 et 17. On aperçoit en outre un chariot d'alimentation 18 dans lequel se trouvent de manière successive les transistors destinés à être préformés. Ce chariot d'alimentation 18 est monté mobile en translation (dans le sens indiqué par les flèches) sur deux arbres 19, 20 au travers de paliers et d'un support 21.

Le but est de synchroniser, de préférence de manière automatique, les déplacements du chariot d'alimentation 18 et des matrices 5, 6 de façon à pincer les pattes de chaque transistor entre les deux matrices et préformer, voire couper, lesdites pattes puis de retirer les matrices 5, 6 et de récupérer la transistor préformé lors du retrait du chariot d'alimentation 18, celui-ci recevant un nouveau transistor non-préformé et le cycle recommençant.

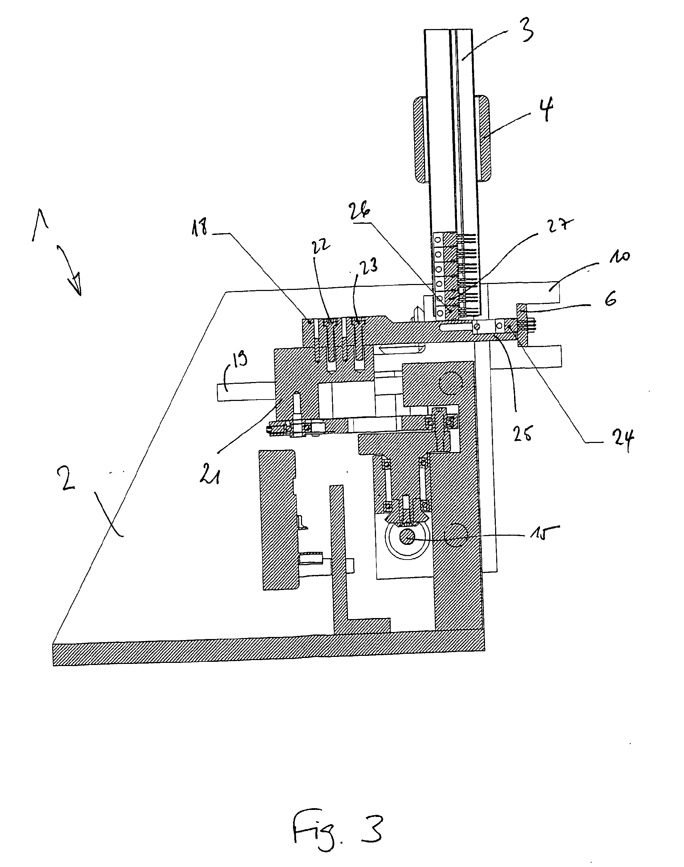

La machine 1 est maintenant décrite en référence à la figure 3. Les élément déjà décrits ci-dessus sont indiqués avec les mêmes références numériques que précédemment. La machine 1 comprend donc le boîtier 2 dans lequel l'on trouve notamment le chariot d'alimentation 18. Ce chariot d'alimentation 18 est monté sur le support 21 au moyen de vis 22, 23 ce qui permet un échange de chariot d'alimentation lorsque le modèle de transistor change (voir les transistors T1, T2 et T3 de la figure 1). A l'extrémité avant du chariot (côté droit de la figure), un transistor 24 destiné à être préformé est placé dans une niche de tenue 25 du chariot d'alimentation 18 qui maintient ledit transistor 24. La figure 3 montre le chariot d'alimentation 18 en position de préformage, c'est-à-dire que les pattes du transistor 24 sont pincées entre les matrices 5, 6, une seule matrice (matrice 6 étant représentée en raison de la coupe). Comme indiqué, par serrage des pattes entre les matrices 5, 6, les pattes du transistor 24 sont déformées, voire même coupées en fonction de la demande.

Une fois l'opération nécessaire effectuée sur les pattes du transistor 24, le transistor 24 est évacué et un nouveau transistor 26 est amené de l'alimentation 3.

Ainsi, en mettant en fonction la machine 1, le moteur entraîne le système de transmission de façon à obtenir l'avancement du chariot d'alimentation 18 avec un transistor 24 (figure 3) introduit à l'extrémité et, à la fin de la course du chariot 18, quand le transistor est en position de travail (telle que représentée à la figure 3 par exemple), les deux matrices façonnées 5, 6 avancent perpendiculairement au transistor 24, l'une vers l'autre, de façon synchronisée commandées par le moteur au travers des axes 11, 12 en étant supportées par les supports 9, 10. Les faces façonnées des matrices 5, 6 se rejoignent en pinçant entre elles les pattes du transistor 24 et effectuent l'opération prévue, par exemple un préformage comme un pliage des pattes ou une coupe de l'une ou l'autre desdites pattes. Dès que cette opération est terminée, il y a une ouverture de matrice 5, 6 par retrait et un retour à la position de départ du chariot d'alimentation 18.

Durant ce retour du chariot 18, le composant préformé tombe de préférence dans un système de récupération de façon à libérer la niche de tenue 25, et en fin de course arrière du chariot d'alimentation 18, la niche ayant été libérée, un nouveau transistor (26 dans la figure 3) est déposé dans la niche de tenue 25. A ce moment, un nouveau cycle de formage commence: le chariot 18 est amené en position, les matrices 5, 6 sont déplacées pour effectuer l'opération prévue, comme ce-dessus, et, une fois l'opération effectue et le matrices 5, 6 retirées, les chariot revient en position de départ pour prendre un nouveau transistor (27 dans la figure 3).

Lorsque l'alimentation 3 est vide, l'on peut soit la remplacer par une nouvelle alimentation identique et recommencer un nouveau cycle de production avec le chariot 18 et les matrices 5, 6 présentes sur la machine, ou alors l'on peut changer les matrices si une opération différentes doit maintenant être effectuées sur les transistors.

De même, il est possible qu'il soit nécessaire de changer de type de transistors, dans ce cas, il est probablement nécessaire de changer à la fois les matrices que le chariot d'alimentation pour que la niche de tenue soit adaptée à la forme et/ou à la taille des nouveaux transistors.

Dans la machine selon l'invention, temps de cycle pour chaque transistor est d'environ 3 secondes. Toutes les étapes sont en principe commandées de manière successive et automatique par des moyens appropriés, par exemple par une commande électrique et/ou électronique du moteur.

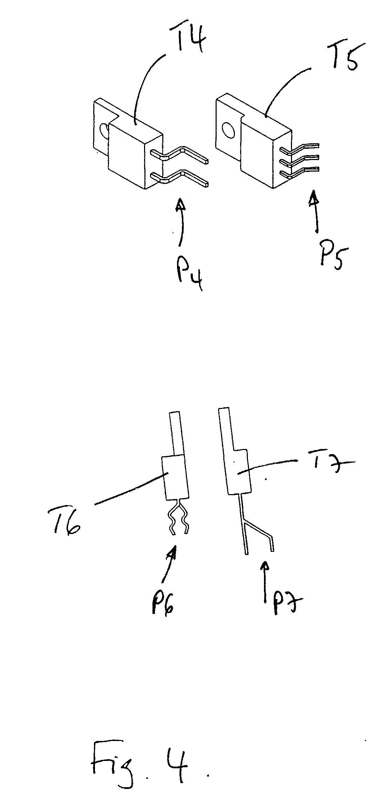

Dans la figure 4, on a représenté plusieurs transistors T4, T5, T6 et T7 avec différentes exemples de configurations de pattes P4, P5, P6, P7 qu'il est possible d'obtenir avec la machine selon l'invention, à l'aide de matrice appropriées.

La machine et le procédé revendiqué ne sont pas limités aux exemples décrits mais peuvent s'applique à d'autres composants électronique. Il est uniquement nécessaire d'adapter, l'alimentation, le chariot d'alimentation, et les matrices en conséquence.

## Revendications

1. Machine de préformage de transistors, **caractérisée en ce qu'**elle comprend au moins
des moyens de déplacement (3,18, 21) pour amener les transistors (T1, T2, T3; 24, 26, 27) dans une position prédéterminée,
des moyens de formage (5,6) pour préformer les pattes desdits transistors,
des moyens d'évacuation des transistors dont les pattes ont été préformées et
des moyens de commande (14,15,16,17) pour coordonner l'action desdits moyens de déplacement, de formage et d'évacuation.

2. Machine selon la revendication 1, **caractérisée en ce que** les moyens de déplacement comprennent au moins un chargeur (3) contenant des transistors (24, 26, 27), un chariot d'alimentation (18) comportant une niche de tenue (25) dans laquelle les transistors successifs dont les pattes ne sont pas préformées sont placés.

3. Machine selon la revendication 1 ou 2, **caractérisée en ce que** les moyens de formage comprennent une matrice de formage (5,6) qui agit sur les pattes d'un transistor amené dans une position prédéterminée.

4. Machine selon l'une des revendications précédentes, **caractérisée en ce que** les moyens d'évacuation comprennent au moins un tiroir d'évacuation.

5. Machine selon l'une des revendications précédentes, **caractérisée en ce que** les moyens de déplacement et les moyens de formage sont démontables et sont destinés à être échangés en fonction des transistors.

6. Procédé de préformage de pattes de transistors, caractérisé au moins par les étapes suivantes:
- ) amenée d'un transistor dans une position prédéterminée;
- ) déplacement d'au moins un matrice de formage;
- ) formage des pattes dudit transistor;
- ) retrait de la matrice;
- ) évacuation du transistor;
- ) amenée d'un nouveau transistor.

7. Procédé selon la revendication 6, **caractérisé en ce qu'**il fait appel à deux matrices de formage dont le déplacement est synchronisé.

8. Procédé selon la revendication 6 ou 7, **caractérisé en ce que** le formage comprend un pliage et/ou une coupe de l'une au moins des pattes du transistor.

9. Procédé selon l'une des revendications 6 à 8, **caractérisé en ce que** les étapes sont commandées de manière successive et automatique.
